Europäisches Patentamt

European Patent Office

Office européen des brevets

(11) Veröffentlichungsnummer: **0 324 114**
**A2**

(12) **EUROPÄISCHE PATENTANMELDUNG**

(21) Anmeldenummer: 88120694.0

(22) Anmeldetag: **10.12.88**

(51) Int. Cl.⁴: **H03M 1/68 , G01C 19/00**

(30) Priorität: **14.01.88 DE 3800804**

(43) Veröffentlichungstag der Anmeldung:
**19.07.89 Patentblatt 89/29**

(84) Benannte Vertragsstaaten:
**AT BE CH DE ES FR GB GR IT LI LU NL SE**

(71) Anmelder: **Bodenseewerk Gerätetechnik GmbH**
**Alte Nussdorfer Strasse 15 Postfach 1120**
**D-7770 Überlingen/Bodensee(DE)**

(72) Erfinder: **Bessel, Jürgen**
**Von Mader Strasse 23**
**D-7770 Überlingen(DE)**

(74) Vertreter: **Weisse, Jürgen, Dipl.-Phys. et al**
**Patentanwälte Dipl.-Phys. Jürgen Weisse**
**Dipl.-Chem. Dr. Rudolf Wolgast Bökenbusch**
**41 Postfach 11 03 86**
**D-5620 Velbert 11 Langenberg(DE)**

(54) Digital-Analog-Wandleranordnung.

(57) Eine Digital-Analog-Wandleranordnung mit großem Dynamikbereich zur Ansteuerung eines Drehmomenterzeugers (34) an einem Kreisel durch ein digitales Signal enthält ein-hochgenau zeitgesteuerten Digital-Analog-Wandler (10) und einen zweiten Digital-Analog-Wandler (12), der Stellensignale parallel in analoge Signale umsetzt und diese analogen Signale zur Bildung eines analogen Ausgangssignals überlagert. An dem Digital-Analog-Wandler (10) liegen von dem zu wandelnden digitalen Signal die Stellensignale relativ hoher Wertigkeit an. An dem Digital-Analog-Wandler (12) liegen die Stellensignale relativ geringer Wertigkeit an. Es sind Mittel (28,36) zur Überlagerung der Signale der beiden Digital-Analog-Wandler (10,12) an dem Drehmomenterzeuger (34) des Kreisels vorgesehen.

Fig.1

Xerox Copy Centre

## Technisches Gebiet

Die Erfindung betrifft eine Digital-Analog-Wandleranordnung mit großem Dynamikbereich zur Ansteuerung eines Drehmomenterzeugers an einem Kreisel durch ein digitales Signal, welches von einer ersten Gruppe von Stellensignalen relativ hoher Wertigkeit und einer zweiten Gruppe von Stellensignalen relativ geringer Wertigkeit gebildet ist.

## Zugrundeliegender Stand der Technik

Die nicht vorveröffentliche deutsche Patentanmeldung P 36 21 953.3 beschreibt eine Trägheitssensoranordnung mit zwei elektrisch gefesselten, zweiachsigen Kreiseln, welche drei zueinander senkrechte Eingangsachsen aufweisen. Abgriffsignale werden nach A/D-Wandlung einem digitalen Rechner zugeführt, der einen Teil des Fesselkreises der Kreisel bildet und digitale Ausgangssignale liefert. Die Ausgangssignale sind auf einen D/A-Wandler geschaltet, der entsprechende Ströme auf die Drehmomenterzeuger der Kreisel gibt.

Es sind Digital-Analog-Wandler bekannt, bei denen an einer Spannung parallel eine Folge von binär gestuften Widerständen liegt. Mit jedem der Widerstände liegt ein Schalter in Reihe. Die Schalter sind üblicherweise elektronisch gesteuerte Schalter, die von je einem Stellensignal eines digitalen Signals, also L oder H, angesteuert werden. Die Ströme in den Widerständen werden zur Bildung eines analogen Ausgangssignals überlagert (Tietze Schenk "Halbleiter-Schaltungstechnik" 2.Aufl. (1971) Springer-Verlag, Seiten 520-529). Diese Digital-Analog-Wandler liefern das analoge Ausgangssignal sehr schnell. Bei digitalen Signalen mit vielen Stellen ergeben sich jedoch Genauigkeitsprobleme: Der Fehler des der höchstwertigen Stelle zugeordneten Stromes, also praktisch der Fehler des betreffenden Widerstandes muß kleiner sein als der Widerstand des der geringstwertigen Stelle zugeordneten Stromes. Sonst wird die Digital-Analog-Wandlung sinnlos.

Bei der Erzeugung von Strömen in den Drehmomenterzeugern von Kreiseln wird ein großer Dynamikbereich von beispielsweise 24 Bit gefordert. Es müssen also Datenwörter von 1 Bit bis 24 Bit möglichst genau in entsprechende analoge Ströme umgesetzt werden. Diese Umwandlung muß möglichst schnell erfolgen. Die bekannten Digital-Analog-Wandler der vorgenannten Art sind nicht in der Lage, den bei Drehmomenterzeugern von Kreiseln geforderten großen Dynamikbereich zu überdecken. ohne die Genauigkeit z.B. durch Bereichsumschaltung zu vermindern.

Bei der FR-PS 2 576 727 werden die höherwertigen Stellen in einen Impuls entsprechender Breite umgesetzt, indem ein von einem Takt beaufschlagter Binärzähler mit einer Eingangszahl in einem Register verglichen wird und bei Gleichheit ein Komparator ein Ausgangssignal umschaltet. Es wird so ein Impuls erzeugt, dessen Breite von den höherwertigen Stellen der Eingangszahl bestimmt wird. Die geringerwertigen Stellen der Eingangszahl steuern unmittelbar eine monostabile Kippschaltung, deren Schaltdauer durch Kondensatoren bestimmt wird. Auch die geringerwertigen Stellen erzeugen so einen Impuls konstanter Amplitude mit einer von den geringerwertigen Stellen bestimmten Dauer.

Es werden also zwei Impulse jeweils konstanter Amplitude aber variabler Dauer erzeugt, allerdings auf zwei verschiedene Weisen für die höherwertigen und die geringerwertigen Stellen. Dabei wird aber bei hoher Auflösung die Gesamtdauer der D/A-Wandlung unerwünscht lang.

Bei der FR-PS 2 550 031 werden die höherwertigen Stellen auf einen Wandler gegeben, der eine gewisse Anzahl von gleichmäßig kurzen Ausgangsimpulsen liefert, deren Anzahl in einer vorgegebenen Umwandlungsperiode dem Wert dieser höherwertigen Stellen entspricht. Die geringerwertigen Stellen werden auf einen Pulsbreitenwandler gegeben, der ein impulsförmiges Ausgangssignal liefert, dessen Dauer diese geringerwertigen Stellen darstellt.

Bei der EP-A 0 141 386 erfolgt eine Pulsbreiten- und eine Pulsamplitudenmodulation für verschiedene Gruppen der Eingangszahl. Bei den höherwertigen Stellen erfolgt eine Pulsamplitudenmodulation und bei den geringerwertigen Stellen erfolgt eine Pulsbreitenmodulation. Die Pulsbreitenmodulation führt bei der Glättung durch ein Tiefpaßfilter zu einer Krümmung der Kennlinie. Das soll durch die Aufteilung vermieden werden.

Bei dieser Anordnung ergibt sich das Problem, daß die Genauigkeit durch die Genauigkeit begrenzt ist, mit welcher die höherwertigen Stellen durch die Stromquellen (oder Widerstände) darstellbar sind.

Andere Anordnungen, bei denen eine Aufteilung der Eingangszahl in Gruppen von Stellen erfolgt, sind bekannt durch die DE-OS 36 06 984, die DE-OS 36 41 676 und die DE-OS 36 32 429.

## Offenbarung der Erfindung

Der Erfindung liegt die Aufgabe zugrunde, Drehmomenterzeuger an Kreiseln mit einem digitalen Signal unter Berücksichtigung der dabei gestellten Anforderungen anzusteuern.

Insbesondere liegt der Erfindung die Aufgabe zugrunde, für diesen Zweck eine Digital-Analog-Wandleranordnung zu schaffen, die eine schnelle Umwandlung eines digitalen Signals in einen Ausgangsstrom mit großem Dynamikbereich gestattet, wobei dieser Ausgangsstrom dann auf den Drehmomenterzeuger aufgeschaltet wird.

Erfindungsgemäß wird diese Aufgabe gelöst durch die Kombination

(a) eines hochgenauen zeitgesteuerten Digital-Analog-Wandlers, der von den Stellensignalen der ersten Gruppe beaufschlagt ist und

(b) eines zweiten Digital-Analog-Wandlers, der die Stellensignale parallel in analoge Signale umsetzt und diese analogen Signale zur Bildung eines analogen Ausgangssignals überlagert, und

(c) Mittel zur Überlagerung der Signale des zeitgesteuerten Digital-Analog-Wandlers und des zweiten Digital-Analog-Wandlers an dem besagten Drehmomenterzeuger des Kreisels.

Der zeitgesteuerte Digital-Analog-Wandlers setzt ein digitales Signal in einen Stromimpuls um, dessen Dauer dem durch das digitale Signal repräsentierten Zahlenwert proportional ist. Wenn aber ein sehr großer Dynamikbereich gefordert wird, dann wird bei dieser Art von Digital-Analog-Wandlern der Wandlerzyklus sehr lang. Es müßten dann nämlich einerseits bei kleinen Zahlenwerten des digitalen Signals noch Impulse erzeugt werden, die bequem verarbeitet werden können, während andererseits bei großen Zahlenwerten des digitalen Signals dann die Impulsdauer ein- dem Dynamikbereich entsprechendes Vielfaches der Impulsdauer bei kleinen Zahlenwerten entspräche. Der Digital-Analog-Wandler reagierte dann sehr träge auf Veränderungen des zu wandelnden digitalen Signals. Das wäre nachteilig bei Regelkreisen wie dem Fesselkreis eines elektrisch gefesselten Kreisels.

Deshalb wird ein solcher Digital-Analog-Wandler bei der Erfindung nur für einen Teil der Stellen des digitalen Signals benutzt, nämlich für eine Gruppe von relativ höherwertigen Stellen. Diese Stellen lassen sich mit hoher Genauigkeit in eine Impusdauer und bei hochgenau konstantem Strom in ein entsprechendes Strom-über-Zeit -Integral umsetzen. Da der Kreisel sowieso integrierend wirkt, schadet es bei dieser Anwendung nichts, wenn das analoge Ausgangssignal impulsförmig erhalten wird. Es ist daher nicht erforderlich, den Stromimpuls durch irgendwelche Filter zu glätten, was wieder die Genauigkeit beeinträchtigen könnte. Dadurch, daß ein solcher zeitgesteuerter Digital-Analog-Wandler nur auf eine Gruppe von relativ höherwertigen Stellen angewandt wird, kann die Länge des Stromimpulses und damit des Wandlerzyklus in Grenzen gehalten werden.

Für die relativ geringerwertigen Stellen des zu wandelnden digitalen Signals ist ein Digital-Analog-Wandler vorgesehen, der die einzelnen Stellensignale des zu wandelnden digitalen Signals parallel, z.B. über entsprechende Widerstände, in analoge Ströme umsetzt und diese Ströme überlagert. Ein solcher Wandler arbeitet sehr schnell. Er hat eine geringere Genauigkeit. Das ist aber weniger kritisch, da die hier verarbeiteten Stellen eine geringere Wertigkeit haben, so daß Fehler sich am Gesamtsignal entsprechend weniger auswirken. Es wird mit diesem zweiten Digital-Analog-Wandler in einem Bereich gearbeitet, in welchem die oben geschilderten Genauigkeitsprobleme beherrschbar sind.

Die Erfindung beruht auf der Erkenntnis, daß sich durch die Kombination der geschilderten beiden Wandlertypen die für den vorliegenden Anwendungsfall gestellten Forderungen nach schneller Bereitstellung der analogen Ausgangssignale und nach einem großen Dynamikbereich mit tragbarem Aufwand erfüllen lassen.

Ausgestaltungen der Erfindung sind Gegenstand der Unteransprüche.

Ein Ausführungsbeispiel der Erfindung ist nachstehend unter Bezugnahme auf die zugehörigen Zeichnungen näher erläutert.

## Kurze Beschreibung der Zeichnungen

Fig.1 ist ein Blockschaltbild und zeigt den Grundaufbau einer Digital-Analog-Wandleranordnung mit zwei unterschiedlichen Typen von Wandlern.

Fig.2 ist ein Blockschaltbild des zeitgesteuerten Digital-Analog-Wandlers bei der Wandleranordnung von Fig.1.

Fig.3 zeigt die Torschaltung, die bei der Wandleranordnung von Fig.1 verwendet wird.

Fig.4 zeigt Signalverläufe bei dem Digital-Analog-Wandler von Fig.1 bis 3.

## Bevorzugte Ausführung der Erfindung

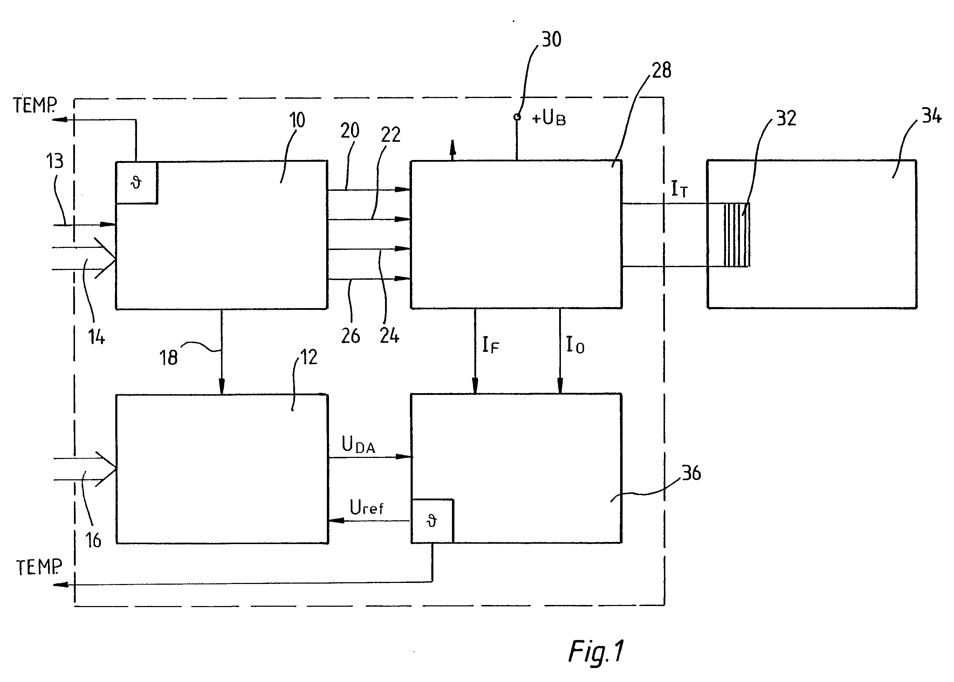

In Fig.1 ist mit 10 ein auf dem Prinzip der Zeitsteuerung beruhender erster Digital-Analog-Wandler bezeichnet. Mit 12 ist ein Digital-Analog-Wandler bezeichnet, der anliegende Stellensignale eines digitalen Signals parallel in analoge, der Wertigkeit der jeweiligen Stelle entsprechende analoge Signale umsetzt und diese analogen Signale zur Bildung eines analogen Ausgangssignals überlagert. Es kann sich dabei um einen Digital-Analog-Wandler handeln, wie er in der oben erwähnten Stelle in dem Buch "Tietze-Schenk" beschrieben ist. Ein (nicht dargestellter) Prozessor liefert ein digitales Signal in Form eines Datenwortes von 24 Bit. Weiterhin liefert der Prozessor an einem Eingang 13 ein Zyklusstartsignal und ein Vorzeichensignal, welches das Vorzeichen des digitalen Signals repräsentiert. Das zu wandelnde digitale Signal ist, wie durch den geteilten Datenbus 14,16 angedeutet ist, in zwei Gruppen von Stellensignalen aufgeteilt: Eine erste Gruppe von Stellensignalen, welche den acht Stellen relativ hoher Wertigkeit entsprechen, ist über Datenbus 14 auf den Digital-Analog-Wandler 10 geschaltet. Eine zweite Gruppe von Stellensignalen, welche den sechzehn Stellen relativ geringer Wertigkeit entsprechen, ist über Datenbus 16 auf den Digital-Analog-Wandler 12 geschaltet. Der zeitgesteuerte Digital-Analog-Wandler 10 gibt, wie noch beschrieben werden wird, ein Synchronisationssignal über einen Ausgang 18 auf den Digital-Analog-Wandler 12. Weiterhin liefert der Digital-Analog-Wandler 10 zwei zueinander komplementäre Vorzeichensignale an Ausgängen 20 und 22 sowie zwei Stromschaltsignale an Ausgängen 24 und 26. Die Vorzeichensignale und die Stromschaltsignale beaufschlagen eine Torschaltung 28 über welche Ströme $I_F$ und $I_o$ von einer Spannungsquelle durch die Wicklung 32 eines Drehmomenterzeugers und über Stromstufen 36 geleitet werden. Die Stromstufen 36 liefern einen hochgenau konstanten Strom $I_o$. Die Stromstufen 36 liefern weiterhin einen variablen Strom $I_F$, welcher durch eine Ausgangsspannung $U_{DA}$ des zweiten Digital-Analog-Wandlers 12 bestimmt ist. Der zweite Digital-Analog-Wandler 12 erhält wiederum eine Referenzspannung $U_{ref}$, die aus dem hochgenau konstanten Strom $I_o$ abgeleitet ist. Auf diese Weise ist sichergestellt, daß der von dem zweiten Digital-Analog-Wandler 12 bestimmte Strom $I_F$ in einem genau definierten Verhältnis zu dem konstanten Strom $I_o$ steht, das durch die Wertigkeit der verschiedenen Stellen bestimmt ist. Wie angedeutet, sind der erste Digital-Analog-Wandler 10 und die Stromstufen 36 temperaturkompensiert.

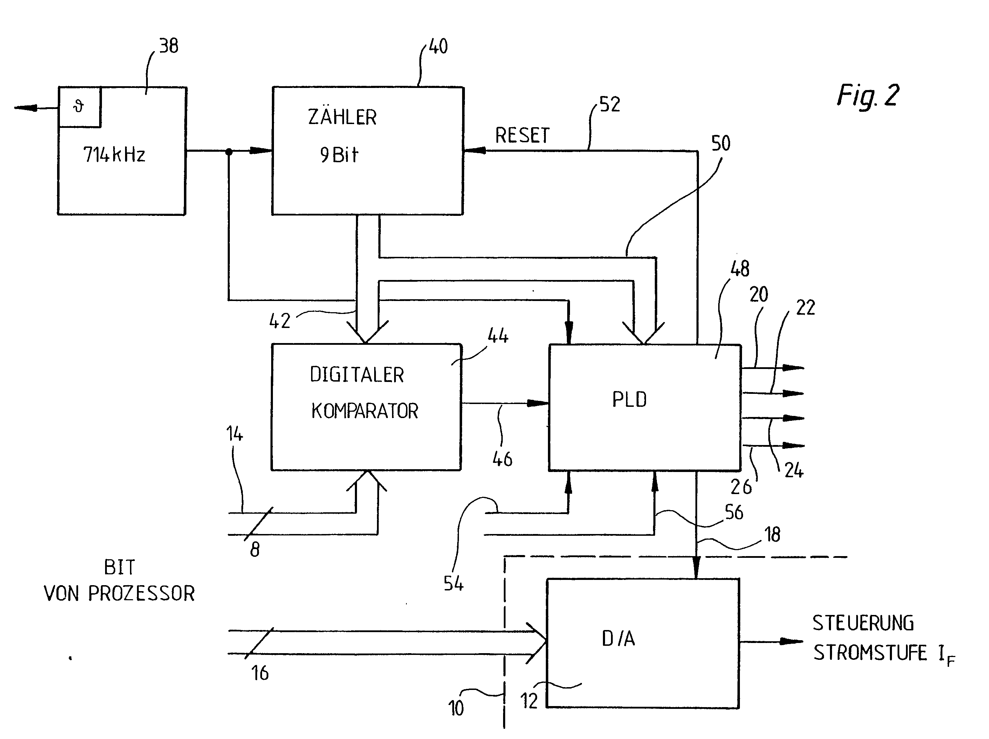

In Fig.2 ist der erste Digital-Analog-Wandler 10 dargestellt, der auf dem Prinzip der Zeitsteuerung beruht. Der Digital-Analog-Wandler 10 enthält einen hochgenauen, quarzgesteuerten und temperaturkompensierten Oszillator 38. Der Oszillator 38 ist mit einem Zähler 40 verbunden. Zur Verarbeitung des digitalen Signals von acht Bit am Eingang hat der Zähler eine Zählerkapazität von neun Bit. Die Zählerausgänge der niedrigstwertigen acht Bit liegen über einen Datenbus 42 an einem digitalen Komparator 44. An dem Komparator 44 liegen weiterhin über Datenbus 14 die acht Bit höchster Wertigkeit des zu wandelnden, digitalen Signals.

Der digitale Komparator 44 liefert an einem Ausgang 46 ein Komparatorausgangssignal. Dieses Komparatorausgangssignal ist auf Impulssteuermittel 48 geschaltet. Die Impulssteuermittel 48 sind von einem programmierbaren Logikbauteil (PLD) gebildet. An den Impulssteuermitteln liegen alle neun Bit des Zählers 40 über einen Datenbus 50. Über eine Leitung 52 liefern die Impulssteuermittel 48 Rücksetzimpulse auf den Zähler 40, wie noch erläutert werden wird. Weiterhin erhalten die Impulssteuermittel 48 ein Zyklusstartsignal von dem Prozessor über eine Leitung 54 und ein Vorzeichensignal über eine Leitung 56. Die beiden Leitungen 54 und 56 bilden den Eingang 13 in Fig.1.

An den Ausgängen 20 und 22 liefern die Impulssteuermittel 48 komplementäre Vorzeichensignale, wie in Fig.1 schon dargestellt ist. An einem Ausgang 24 erscheint ein Signal, durch welches der konstante Strom $I_o$ einschaltbar ist. An einem Ausgang 26 erscheint ein Signal, durch welches der variable Strom $I_F$ eingeschaltet wird. Die Impulssteuermittel 48 liefern weiterhin an dem Ausgang 18 das Synchronisationssignal, durch welches der zweite Digital-Analog-Wandler 12 mit dem ersten synchronisiert wird.

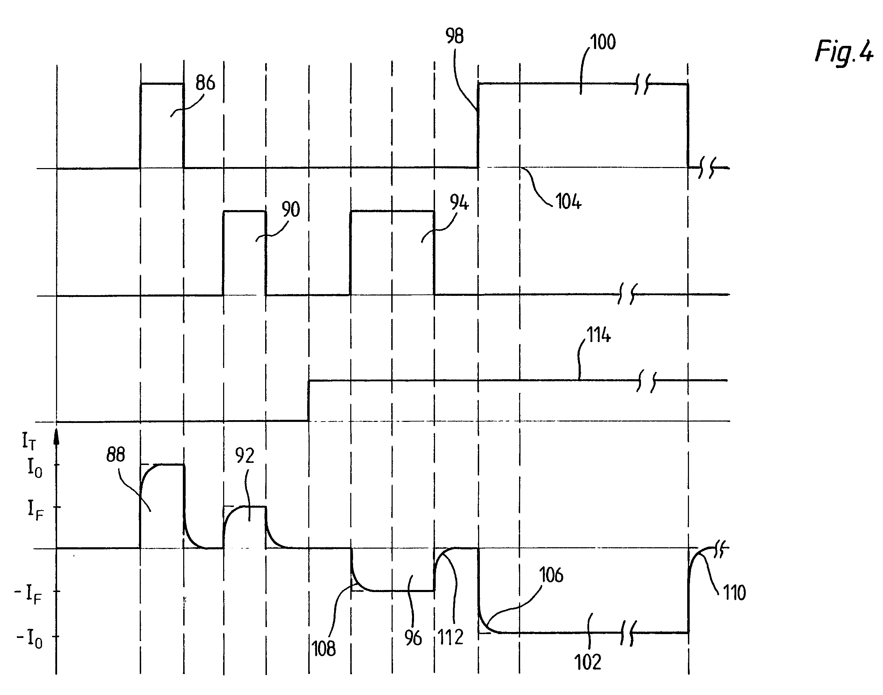

Die Impulssteuermittel 48 sind so programmiert, daß die in Fig.4 dargestellten und unten beschriebenen Signalverläufe entstehen. Die Programmierung ist dem Fachmann bei Kenntnis der vorliegenden Beschreibung geläufig und daher hier nicht im einzelnen beschrieben.

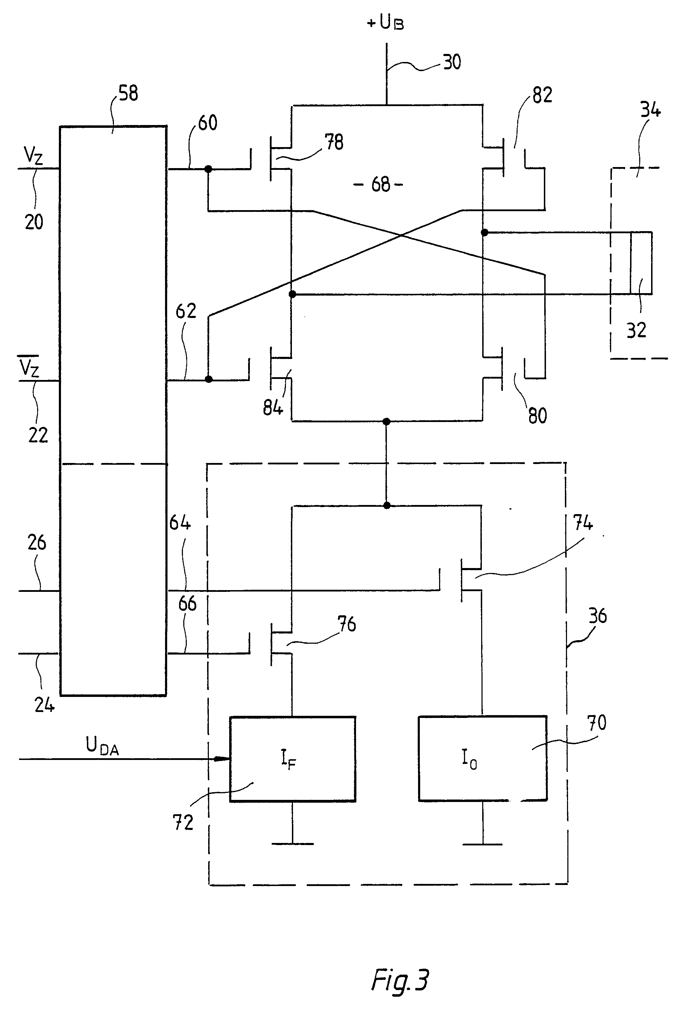

In Fig.3 ist sind Torschaltung 28 dargestellt, die von den Signalen an den Ausgängen 20,22,24 und 26 der Impulssteuermittel 48 gesteuert ist, sowie die Stromstufen 36 von Fig.1.

Die Ausgänge 20,22,24 und 26 sind über eine Schalter -Schnittstelle 58 auf Steuerklemmen 60,62,64 bzw. 66 geschaltet.

Ein Strompfad verläuft von der Spannungsquelle 30 über eine Schalterbrücke 68, die Wicklung 32 des Drehmomenterzeugers 34 und die Stromstufen 36. Die Stromstufen 36 enthalten Stromregler 70 bzw. 72 und in Reihe damit gesteuerte, elektronische Schalter 74 bzw. 76. Die Reihenschaltungen von Stromregler und Schalter liegen parallel und sind über eine Diagonale der Schalterbrücke 68 mit der Spannungsquelle 30 verbunden. Der gesteuerte, elektronische Schalter 74 ist von dem Signal an der Steuerklemme 64 gesteuert, das von dem Signal am Ausgang 24 der Impulssteuermittel 48 abgeleitet ist. Der gesteuerte, elektronische Schalter 76 ist von dem Signal an der Steuerklemme 66 gesteuert, das von dem Signal am Ausgang 26 der Impulssteuermittel 48 abgeleitet ist. Es kann auf diese Weise über die Ausgänge 24 und 26 entweder der Strom $I_o$ oder der Strom $I_F$ aufgeschaltet werden oder gar kein Strom.

Die Schalterbrücke 68 enthält in ihren vier Zweigen vier gesteuerte, elektronische Schalter 78,80,82 und 84. Die Steuerelektroden der Schalter 78 und 80 sind mit der Steuerklemme 60 verbunden. Die Schalter 78 und 80 werden also von dem ersten Vorzeichensignal an dem Ausgang 20 gesteuert. Die Schalter 82 und 84 sind mit der Steuerklemme 62 verbunden. Die Schalter 82 und 84 werden also von dem zu dem ersten komplementären Vorzeichensignal an dem Ausgang 22 gesteuert. An einer Diagonale der Schalterbrücke 68 liegt, wie schon beschrieben, die Spannungsquelle 30 mit den Stromstufen 36. An der anderen Diagonale der Schalterbrücke 68 liegt die Wicklung 32 des Drehmomenterzeugers 34.

Diese Schaltung wirkt wie folgt:

Wenn das Signal am Ausgang 20 die beiden Schalter 78 und 89 aufsteuert, dann fließt der Strom von der Spannungsquelle 30 über Schalter 78, die Wicklung 32 (von unten nach oben in Fig.3) und den Schalter 80 zu den Stromstufen. Je nachdem, welcher der beiden Schalter 74 und 76 von den Ausgängen 24 bzw. 26 der Impulssteuermittel aufgesteuert ist, fließt dabei der Strom $I_0$ oder der Strom $I_F$. Die beiden Schalter 82 und 84 bleiben dann gesperrt, weil das Signal am Ausgang 22 stets komplementär zu dem Signal am Ausgang 20 ist. Wenn durch das Signal am Ausgang 22 die beiden Schalter 82 und 84 aufgesteuert, also leitend, werden, geht der Stromfluß von der Spannungsquelle 30 über Schalter 82 durch die Wicklung 32 des Drehmomenterzeugers 34 (von oben nach unten in Fig.3) und über den Schalter 84 zu den Stromstufen 36. Die Schalter 78 und 80 sind dann gesperrt.

Die Wirkungsweise des beschriebenen Digital-Analog-Wandlers wird nachstehend anhand der Signalverläufe von Fig.4 erläutert.

Ein Startimpuls von dem Prozessor started den Wandlerzyklus. Der Zähler 40 wird auf null zurückgesetzt. Der Zähler hat bei dem beschriebenen Ausführungsbeispiel eine Zählerkapazität von neun Bit, zählt also bis 512. Gleich zu Beginn des Wandlerzyklus wird ein Impuls 86 erzeugt. Der Impuls 86 hat die Dauer einer Periode des Zählsignals von Oszillator 38. Dieser Impuls 86 macht den Schalter 74 über Ausgang 64 und die Schalter 82 und 84 über Ausgang 22 leitend. Es fließt ein Strom $I_T$ gemäß Impuls 88 durch die Wicklung 32. Wie aus Fig. 4 letzte Zeile ersichtlich ist, folgt der Strom durch die Wicklung 32 nicht dem idealen Rechteckverlauf des Steuerimpulses 86 sondern steigt nach einer Exponentialkurve auf den Endwert $I_0$ an und klingt entsprechend nach einer exponentialkurve ab.

In der dritten Periode der Zählsignale erscheint ein Steuerimpuls 90 am Ausgang 26. Es wird dann der Strom $I_F$ über Ausgang 26 und Schalter 76 aufgeschaltet. Über Ausgang 20 und Schalter 78 und 80 fließt dieser Strom ebenfalls von unten nach oben durch die Wicklung 32. Auch hier ist der Kurvenverlauf 92 gegenüber dem rechteckigen Steuerimpuls in der ansteigenden und der abfallenden Flanke abgerundet.

In der sechsten und siebenten Periode der Zählsignale erscheint wieder ein Steuerimpuls 94. Dieser Steuerimpuls liegt wieder an dem Ausgang 26, schaltet also den variablen Strom $I_F$ auf. Die Vorzeichensignale sind jetzt aber umgekehrt. Es werden über den Ausgang 22 die Schalter 82 und 84 leitend gemacht. Dadurch fließt der Strom $I_F$ mit umgekehrtem Vorzeichen von oben nach unten durch die Wicklung 32. Es ergibt sich der negative Impuls 96 in der letzten Zeile von Fig.4.

Nach der achten Periode der Zählsignale wird über den Signalanstieg 98 wieder der gesteuerte, elektronische Schalter 74 über Ausgang 24 durchgeschaltet. Es ist wieder der konstante Strom $I_0$ aufgeschaltet. Über Ausgang 22 bleiben jedoch die Schalter 82 und 84 leitend, so daß der Strom ebenfalls von oben nach unten durch die Wicklung 32 fließt und ein "negativer" Impuls entsteht. Dieser Zustand bleibt bestehen. Nach der neunten Periode der Zählsignale wird der Zähler auf null gestellt. Von diesem Zeitpunkt an werden die acht geringstwertigen Stellen des Zählerstand mit den acht Stellensignalen am Datenbus 14 durch den digitalen Komparator 44 verglichen. Der Impuls bleibt stehen, bis der Zählerstand dem durch die acht Stellensignale repräsentierten Zahlenwert entspricht, und der Komparator 44 das Komparatorausgangssignal an dem Ausgang 46 liefert.

Es entsteht also ein Steuerimpuls 100 der von dem Signalanstieg 98 nach acht Perioden des Zählsignals insgesamt eine Länge $(n+1)T_0$ hat, wenn n der Zahlenwert ist, der durch die Stellensignale an dem Datenbus 14 repräsentiert ist, und $T_0$ die Periode der Zählsignale bedeutet. Dieser Steuerimpuls 100 schaltet den konstanten Strom $I_0$ auf die Wicklung 32 des Drehmomenterzeugers 34. Dabei fließt der Strom von oben nach unten in Fig.4 durch die Wicklung 32, was als "negatives" Signal angenommen werden soll. Der so erzeugte Stromimpuls ist um eine Periode des Zählsignals länger als es dem zu wandelnden Zahlenwert n entspricht. Der Stromimpuls 102 beginnt schon mit dem Anstieg 98 des Steuerimpulses und nicht erst bei 104, wenn der Zähler 40 auf null zurückgesetzt ist. Die Stromimpulse 102 und 96 sind keine sauberen Rechteckimpulse. Sie zeigen einen abgerundeten Anstieg 106 bzw. 108 und entsprechend einen abklingenden Abstieg 110 bzw. 112. Da für die Digital-Analog-Wandlung das Zeitintegral der Stromimpulse gebildet wird, führt das zu einem Fehler.

Aus diesem Grunde werden die beiden "Vorimpulse" 88 und 92 erzeugt. Zur Erzeugung des Vorimpulses 88 wird der konstante Strom $I_0$ auf die Wicklung 32 geschaltet wie bei dem Impuls 102. Die Aufschaltung erfolgt aber über die Schalter 78 und 80. so daß der Strom von unten nach oben, also "positiv" durch die Wicklung 32 fließt. Die Dauer des Vorimpulses 88 ist eine Periode $T_o$ der Zählsignale. Bei der Integration kompensiert der Vorimpuls 88 die um $T_o$ zu große Länge des Stromimpulses 102, so daß tatsächlich ein resultierender Stromimpuls von $nT_o$ in der Wicklung 32 wirksam wird. Es heben sich dabei aber auch die Einflüsse des abgerundeten Anstiegs des Stromimpulses 102 und des abklingenden Abfalls heraus, da der Vorimpuls 88 natürlich genau das gleiche Zeitverhalten zeigt. Es läßt sich daher ein resultierender Stromimpuls erzeugen, der mit großer Genauigkeit dem Zahlenwert n mit einem sehr genau definierten Proportionalitätsfaktor $T_o$ proportional ist.

Mit 114 in Fig.4 ist das Vorzeichen- Steuersignal Vz bezeichnet, welches die Schalterbrücke 68 steuert. Es ist erkennbar, daß zwischen den "Vorimpulsen" 88 und 92 und den "Meßimpulsen" 102 und 96 jeweils eine Vorzeichenumkehr stattfindet. Wenn die Vorzeichen der Stromimpulse 102 und 96 positiv wären, würden die Vorimpulse negativ.

Die Impulssteuermittel 48 erzeugen bei der Rücksetzung des Zählers nach neun Perioden des Zählsignals bei 104 ein Signal am Ausgang 18, durch welches die Digital-Analog-Wandlung des Digital-Analog-Wandlers 12 für den jeweils nächsten Wandlerzyklus eingeleitet wird.

Der Digital-Analog-Wandler 12 liefert seiner Natur nach einen konstanten Strom. Da aber ein solcher Strom, wenn er über den gesamten Wandlerzyklus hinweg fließen würde, wegen der zeitlichen Integration in seinem Verältnis zu dem konstanten Strom $I_o$ unter Berücksichtigung der Wertigkeiten der Stellen u.U. sehr klein wäre und durch Rauschen beeinträchtigt würde, wird auch das Ausgangssignal des Digital-Analog-Wandlers 12 impulsartig aufgeschaltet. Der Stromimpuls 96 ist ein Impuls konstanter Länge aber mit variablem Strom $I_F$. Die Länge wird durch die Periode der Zählsignale sehr genau festgelegt. Der Strom $I_F$ kann entsprechend größer gewählt werden.

Bei diesem Stromimpuls 96 treten die gleichen Probleme auf wie bei dem Stromimpuls 102, nämlich daß ein abgerundeter Anstieg und ein abklingender Abfall des Stromes an der Vorder- bzw. Rückflanke auftritt. Das wird wi bei dem Stromimpuls 102 kompensiert dadurch, daß der Stromimpuls 96 eine Länge von $2T_o$ hat und ein Vorimpuls 92 von entgegengesetztem Vorzeichen erzeugt wird.

Der Zähler 40 hat nicht nur die Funktion, durch Vergleich des Zählerstandes mit dem Zahlenwert, der durch die anliegenden Stellensignale repräsentiert ist, die Länge des Stromimpulses 102 zu bestimmen. Vielmehr steuert der Zähler 40 in Verbindung mit den Impulssteuermitteln 48, also dem programmierbaren Logikbaustein, den gesamten Ablauf einschließlich der Vorimpulse 88 und 92 und der impulsartigen Aufschaltung des Stromes $I_F$. Dadurch ist eine genaue Synchronisierung der Impulse gewährleistet. Die Zählerkapazität ist größer als es für den reinen Vergleich durch den digitalen Komparator 44 erforderlich wäre, um für diese Steuerfunktion Raum zu schaffen.

## Ansprüche

1. Digital-Analog-Wandleranordnung mit großem Dynamikbereich zur Ansteuerung eines Drehmomenterzeugers (34) an einem Kreisel durch ein digitales Signal,welches von einer ersten Gruppe von Stellensignalen relativ hoher Wertigkeit und einer zweiten Gruppe von Stellensignalen relativ geringer Wertigkeit gebildet ist,
**gekennzeichnet durch die Kombination**

(a) eines hochgenauen zeitgesteuerten Digital-Analog-Wandlers (10), der von den Stellensignalen der ersten Gruppe beaufschlagt ist und

(b) eines zweiten Digital-Analog-Wandlers (12), der die Stellensignale parallel in analoge Signale umsetzt und diese analogen Signale zur Bildung eines analogen Ausgangssignals überlagert, und

(c) Mittel (28,36) zur Überlagerung der Signale des zeitgesteuerten Digital-Analog-Wandlers (10) und des zweiten Digital-Analog-Wandlers (12) an dem besagten Drehmomenterzeuger (34) des Kreisels.

2. Digital-Analog-Wandleranordnung nach Anspruch 1, **dadurch gekennzeichnet, daß**

(a) durch den zeitgesteuerten Digital-Analog-Wandler (10) während jedes Wandlerzyklus ein erster Stromimpuls (102) mit einem konstanten Strom ($I_o$) von einer hochgenauen Stromquelle für eine Zeitdauer erzeugbar ist, die dem durch die Stellensignale der ersten Gruppe bestimmten Zahlenwert (n) erhöht um einen festen Betrag (1) mit einem Proportionalitätsfaktor ($T_o$) proportional ist, und

(b) durch den zeitgesteuerten Digital-Analog-Wandler (10) weiterhin ein zweiter Stromimpuls (88) mit dem gleichen konstanten Strom ($I_o$) von der hochgenauen Stromquelle, einer dem besagten festen Betrag mit dem gleichen Proportionalitätsfaktor proportionalen Zeitdauer ($T_o$) und gegenüber dem ersten Stromimpuls (102) umgekehrten Vorzeichen erzeugbar ist.

3. Digital-Analog-Wandleranordnung nach Anspruch 1 oder 2, **dadurch gekennzeichnet, daß** der zweite Digital-Analog-Wandler (12) als analogen Ausgangswert einen Stromimpuls (96) konstanter Dauer mit einem Strom erzeugt, der nach Maßgabe des durch die Stellensignale der zweiten Gruppe bestimmten Zahlenwertes veränderlich ist.

4. Digital-Analog-Wandleranordnung nach Anspruch 3, **dadurch gekennzeichnet, daß**

(a) die Zeitdauer des Stromimpulses (96) des zweiten Digital-Analog-Wandlers (12) um einen festen Betrag ($T_o$) größer ist, als es der Wertigkeit der Stellensignale der zweiten Gruppe im Verhältnis zu denen der ersten Gruppe entspricht.

(b) der zweite Digital-Analog-Wandler (12) einen zweiten Stromimpuls (92) erzeugt, dessen Zeitdauer dem besagten festen Betrag ($T_o$) entspricht und dessen Strom ($I_F$) entgegengesetzt gleich dem Strom des ersten Stromimpulses (96) von dem zweiten Digital-Analog-Wandler (12) ist.

5. Digital-Analog-Wandleranordnung nach Anspruch 1, **dadurch gekennzeichnet, daß** der erste Digital-Analog-Wandler (10)

(a) einer hochkonstanten Oszillator (38) enthält sowie

(b) einen Zähler (40), an dem Zählsignale des Oszillators (38) anliegen,

(c) einen digitalen Komparator (44), an welchem einerseits Ausgänge des Zählers (40) und andererseits die Stellensignale der zweiten Gruppe anliegen und der bei vorgegebener Beziehung der anliegenden Ausgänge des Zählers (40) und der Stellensignale der zweiten Gruppe ein Komparatorausgangssignal liefert, und

(d) Impulssteuermittel (48) zur Erzeugung des ersten Stromimpulses (102), die von dem Komparatorausgangsimpuls beaufschlagt sind und den ersten Stromimpuls (102) von einem vorgegebenen Zeitpunkt (98) des Wandlerzyklus bis zu dem Komparatorausgangssignal abgeben.

6. Digital-Analog-Wandleranordnung nach Anspruch 5, **dadurch gekennzeichnet, daß**

(a) der Zähler (40) zu Beginn jedes Wandlerzyklus auf null rücksetzbar ist,

(b) die Zählerkapazität des Zählers (40) eine Stelle mehr enthält als die erste Gruppe von Stellensignalen des zu wandelnden digitalen Signals,

(c) an dem Komparator (44) die Ausgänge des Zählers (40) mit Ausnahme des Ausganges anliegen, der der Stelle höchster Wertigkeit entspricht,

(d) der Komparator (44) bei Gleichheit der Datenworte an seinen Eingängen das Komparatorausgangssignal liefert und

(e) die Impulssteuermittel (48) von allen Ausgängen des Zählers (40) beaufschlagt sind,

(f) die Impulssteuermittel (48) bei einem ersten, vorgegebenen, geringen Zählerstand den Zähler (40) auf null zurückstellen und dann zum Vergleich mit den am Komparator (44) anliegenden Stellensignalen neu starten

7. Digital-Analog-Wandleranordnung nach Anspruch 6, **dadurch gekennzeichnet, daß** die Impulssteuermittel (48) von einem programmierbaren Logikbaustein (PLD) gebildet sind.

8. Digital-Analog-Wandleranordnung nach den Ansprüchen 1 bis 7, **dadurch gekennzeichnet, daß** der programmierbare Logikbaustein

(a) von einem Prozessor, welcher das zu wandelnde Digitalsignal liefert, außerdem ein Zyklusstartsignal und ein Vorzeichensignal erhält,

(b) ein erstes Stromschaltsignal liefert, durch welches der besagte konstante Strom ($I_o$) zur Erzeugung des ersten und des zweiten Stromimpulses des ersten Digital-Analog-Wandlers (10) durchschaltbar ist.

(c) ein Synchronisationssignal liefert, durch welches eine Synchronisation des zweiten Digital-Analog-Wandlers (12) mit dem ersten Digital-Analog-Wandler (10) erfolgt,

(d) ein zweites Stromschaltsignal liefert, durch welches der nach Maßgabe der Stellensignale der zweiten Gruppe veränderliche Strom ($I_F$) zur Erzeugung des ersten und des zweiten Stromimpulses (96,92) des zweiten Analog-Digital-Wandlers (12) durchschaltbar ist,

(e) Vorzeichensignale durch welche die ersten Stromimpulse (102,96) mit einer durch das Vorzeichensignal vom Prozessor bestimmten Polarität und die zweiten Stromimpulse (88,92) mit entgegengesetzter Polarität auf den Drehmomenterzeuger (34) des Kreisels aufschaltbar sind.

9. Digital-Analog-Wandleranordnung nach Anspruch 8, **dadurch gekennzeichnet, daß**

(a) die Vorzeichensignale zwei zueinander komplementäre Digitalsignale sind,

(b) vier gesteuerte, elektronische Schalter (78,80,82,84) in einer Brückenschaltung (68) angeordnet sind, an deren einer Diagonale eine der Stromquellen für konstanten oder variablen Strom anlegbar ist und an deren anderer Diagonale eine Wicklung (32) des Drehmomenterzeugers (34) liegt, und

(c) jedes der Vorzeichensignale eine Paar von diagonal gegenüberliegenden Schaltern (78.80 bzw. 82,84) dieser Brückenschaltung (68) steuert.

Fig.1

Fig. 2

ϑ
714 kHz — 38

ZÄHLER 9 Bit — 40

RESET — 52

50

DIGITALER KOMPARATOR — 44

42

46

PLD — 48

20
22
24
26

56

54

18

D/A — 12

10

16

14

8

BIT VON PROZESSOR

STEUERUNG STROMSTUFE $I_F$

*Fig.3*

Fig.4

EP 0 324 114 A2